(19) Europäisches Patentamt
European Patent Office
Office européen des brevets

(11) **EP 4 700 476 A2**

(12) **EUROPEAN PATENT APPLICATION**

(43) Date of publication:
**25.02.2026 Bulletin 2026/09**

(51) International Patent Classification (IPC):
***G03F 7/00*** (2006.01)

(21) Application number: **25222267.4**

(22) Date of filing: **10.12.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(71) Applicant: **ASML Netherlands B.V.**
**5500 AH Veldhoven (NL)**

(72) Inventor: **KOK, Gijs**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD OF DETERMINING A MEASUREMENT REGION IN IMAGES, APPARATUS AND COMPUTER PROGRAM**

(57) Disclosed is a method of determining a measurement region comprising: obtaining at least one variation map derived from signals of a plurality of metrology targets, the at least one variation map comprising a plurality of data points, indicating a variation of a component of the signals collected from a corresponding location of the plurality of metrology targets, the component of the signals not being indicative of a parameter of interest; defining a cost function for optimizing a measurement region in images of the plurality of metrology targets, comprising a first term relating to a variation of the data points whose corresponding locations of the metrology targets falling within a default measurement region of the at least one variation map, a second term relating to an impact of a size of the default measurement region on measurement repeatability; and using the cost function to determine the measurement region of the images.

800

```
┌─────────┐
│   810   │
└────┬────┘
     │
     ▼
┌─────────┐
│   820   │
└────┬────┘
     │
     ▼
┌─────────┐
│   830   │
└─────────┘
```

**Fig. 8**

EP 4 700 476 A2

**Description**

FIELD OF THE INVENTION

The present invention relates to methods and apparatuses for metrology usable, for example, in the manufacture of devices by lithographic techniques and to methods of manufacturing devices using lithographic techniques.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., gratings of $40\mu m$ by $40\mu m$ and the measurement beam generates a spot that is smaller than the grating (i.e., the grating is underfilled). This simplifies mathematical reconstruction of the target as it can be regarded as infinite. However, in order to reduce the size of the targets, e.g., to $10\mu m$ by $10\mu m$ or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO2009078708A1 and WO2009106279A1 which documents are hereby incorporated by reference in their entirety. Further developments of the technique have been described in patent publications US2011027704A1, US2011043791A1 and US20120242970A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

In the known metrology technique, overlay measurement results are obtained by measuring the target twice under certain conditions, while either rotating the target or changing the illumination mode or imaging mode to obtain separately the -1st and the +1st diffraction order intensities. The intensity asymmetry, a comparison of these diffraction order intensities, for a given target provides a measurement of target asymmetry, that is asymmetry in the target. This asymmetry in the target can be used as an indicator of overlay (undesired misalignment of two layers), i.e., positional error in the substrate plane and/or an indicator of focus i.e., positional error perpendicular to the substrate plane. Another known method measures a phase difference between dark-field images of two different types of sub-target.

As the target size decreases beyond the aforementioned $10\mu m$ size, e.g., to less than $9\mu m$, less than $8\mu m$, less than $7\mu m$ or less than or equal to $6\mu m$, the region of interest (ROI), corresponding to a region of the target over which the sensed diffraction order intensity is averaged, also decreases. Bright edges often arise in the images of metrology targets due to edge effects, due to light leaking from the target edges into the interior of the measurement region. This leakage distorts intensity readings, which is critical for methods relying on average intensities from gratings. The ROI is a measurement region that may be obtainable from measured or simulated metrology images. The ROI selection may have a direct impact on resulting parameter of interest (e.g overlay) accuracy, or throughput when the data needs to be input to a model for parameter of interest inference.

It is therefore desirable to provide a better method of determining a measurement region from metrology images so as to improve performance indicator at parameter of interest inference.

SUMMARY

In a first aspect of the invention there is provided a method of determining a measurement region, comprising: obtaining at least one variation map derived from signals of a plurality of metrology targets, wherein the at least one variation map each comprises a plurality of data points, each data point indicating a variation of a component of the signals collected from a corresponding location of the plurality of metrology targets and the component of the measured signals not being indicative of a parameter of interest; defining a cost function for optimizing a measurement region in images of the plurality of metrology targets, wherein the cost function comprises a first term relating to a variation of the data points whose corresponding locations of the metrology targets falling within a default measurement region of the at least one variation map, and a second term relating to an impact of a size of the default measurement region on measurement repeatability; and using the cost function to determine the measurement region of the images.

In another aspect a computer program comprising processor readable instructions which, when run on suitable processor-controlled apparatus, cause the processor-controlled apparatus to perform the method of the first aspect and a computer program carrier comprising such a computer program. The processor-controlled apparatus may comprise a metrology apparatus or processing arrangement therefor.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying drawings in which:

Figure 1 schematically depicts a lithographic apparatus;
Figure 2 schematically depicts a lithographic cell or cluster;
Figure 3 depicts a schematic representation of holistic lithography, representing a cooperation between key technologies to optimize semiconductor manufacturing;
Figure 4 is a schematic illustration of a scatterometry apparatus for metrology;
Figure 5(a) comprises a schematic diagram of a dark field scatterometer for metrology for use in measuring targets according to embodiments of the invention using a first pair of illumination apertures;
Figure 5(b) illustrates a detail of diffraction spectrum of a target grating for a given direction of illumination;
Figure 5(c) illustrates a second pair of illumination apertures providing further illumination modes in using the scatterometer for diffraction based overlay measurements; and
Figure 5(d) illustrates a third pair of illumination apertures combining the first and second pair of apertures;
Figure 6 depicts a known form of multiple grating target and an outline of a measurement spot on a substrate;
Figure 7 depicts an image of the target of Figure 6 obtained in the scatterometer of Figure 5;
Figure 8 is a flowchart describing a method of determining a region of interest according to concepts disclosed herein;
Figure 9 is a flowchart describing a method of determining a variation map for use in the method of

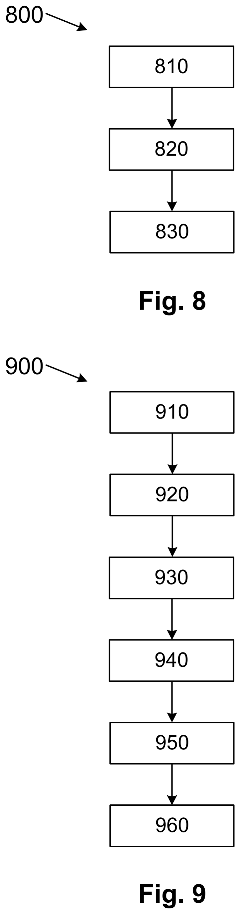

Figure 8, in accordance with an embodiment;

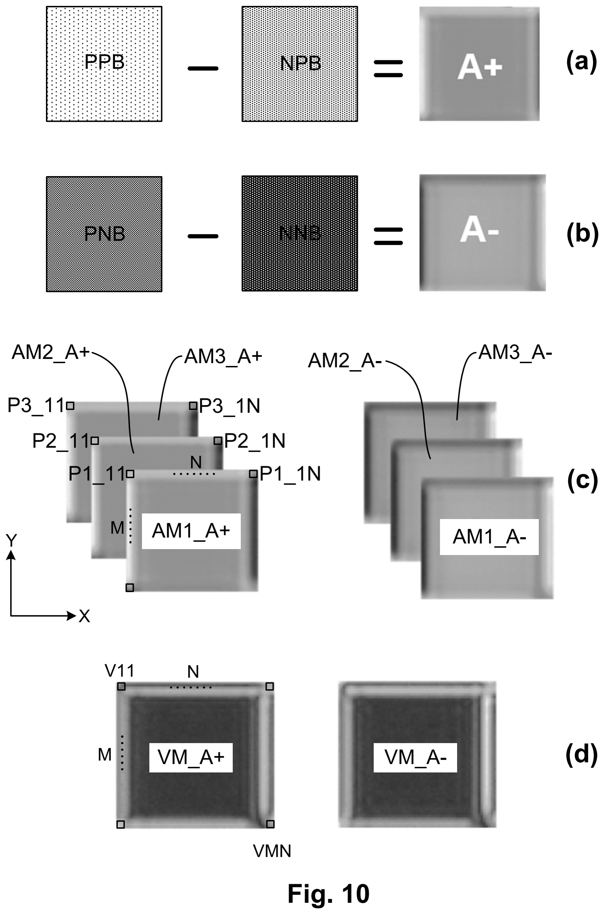

Figures 10(a)-10(d) are schematic diagrams illustrating the process of generating variation maps from images of biased sub-targets, in accordance with an embodiment; and

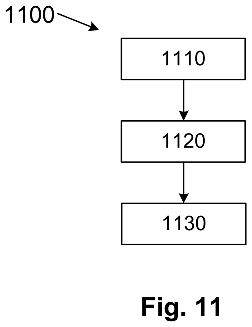

Figure 11 is a flowchart describing a method of selecting a pattern recognition technique for use in the method of Figure 8 or 9, in accordance with an embodiment.

DETAILED DESCRIPTION OF EXEMPLARY EMBODIMENTS

Before describing embodiments of the invention in detail, it is instructive to present an example environment in which embodiments of the present invention may be implemented.

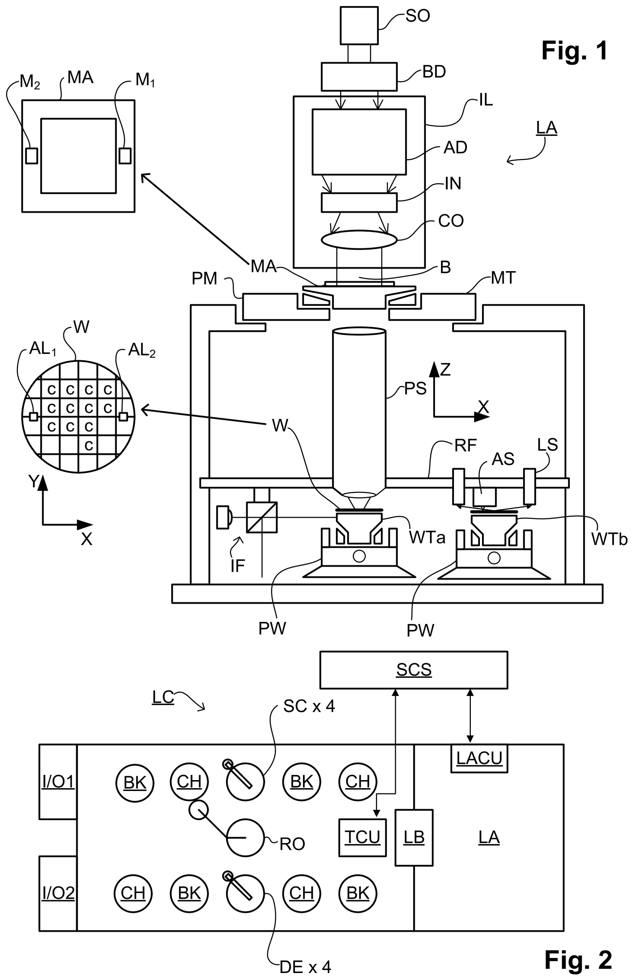

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WTa, WTb, constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W. In addition, the lithographic apparatus includes a reference frame RF.

The illumination optical system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks $M_1$, $M_2$ and substrate alignment marks $AL_1$, $AL_2$. Although the substrate alignment marks as illustrated occupy dedicated target portions, they may be located in spaces between target portions (these are known as scribe-lane alignment marks).

Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

As shown in Figure 2, a lithographic apparatus corresponding to the lithographic apparatus LA of Figure 1, forms part of a lithographic system, referred to as a lithographic cell LC, a lithocell or a cluster. The lithographic cell LC may also include apparatus to perform pre- and post-exposure processes on a substrate. Conventionally these include the following process devices: spin coaters SC to deposit resist layers, developers DE to develop exposed resist, chill plates CH and bake plates BK. A substrate handler, or robot, RO picks up substrates from input/output ports I/O1, I/O2, moves them between the different process devices and delivers them to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection tool, which may also be referred to as a metrology tool or metrology apparatus, is used to determine properties of the substrates W, and in particular, how properties of different substrates W vary or how properties associated with different layers of the same substrate W vary from layer to layer. The inspection tool may alternatively be constructed to identify defects on the substrate W and may, for example, be part of the lithocell LC, or may be integrated into the lithographic apparatus LA, or may even be a stand-alone device. The inspection tool may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

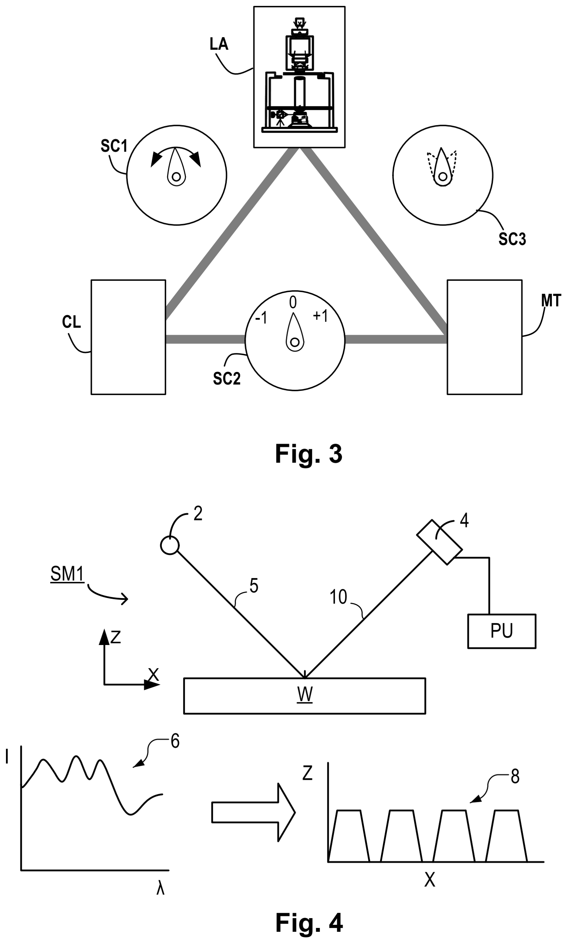

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent publications US20100328655A1, US2011102753A1, US20120044470A1, US20110249244A1, US20110026032A1 or EP1628164A2, incorporated herein by reference in their entirety. Aforementioned scatterometers can measure in one image multiple targets from multiple gratings using light from soft x-ray and visible to near-IR wave range.

A metrology apparatus is depicted in Figure 4 as scatterometer SM1. The scatterometer SM1 comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 of the substrate giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer is a spectroscopic scatterometer. In such spectroscopic scatterometer, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patents US7791724B2, US7701577B2, US8115926B2, US8553227B2, US8681312B2, US8792096B2, US8823922B2, US8692994B2, US13/533110 and US8797554B2 incorporated herein by reference in their entirety.

In one embodiment of the scatterometer, the scatterometer is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1628164A2, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO2011012624A1 or US patent application US20160161863A1, incorporated herein by reference in its entirety. Other parameters of interest may be focus and dose. Focus and dose may be determined simultaneously by scatterometry (or alternatively by scanning electron microscopy) as described in US patent application US20110249244A1, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US20160161863A1 and published US patent application US20160370717A1 incorporated herein by reference in its entirety.

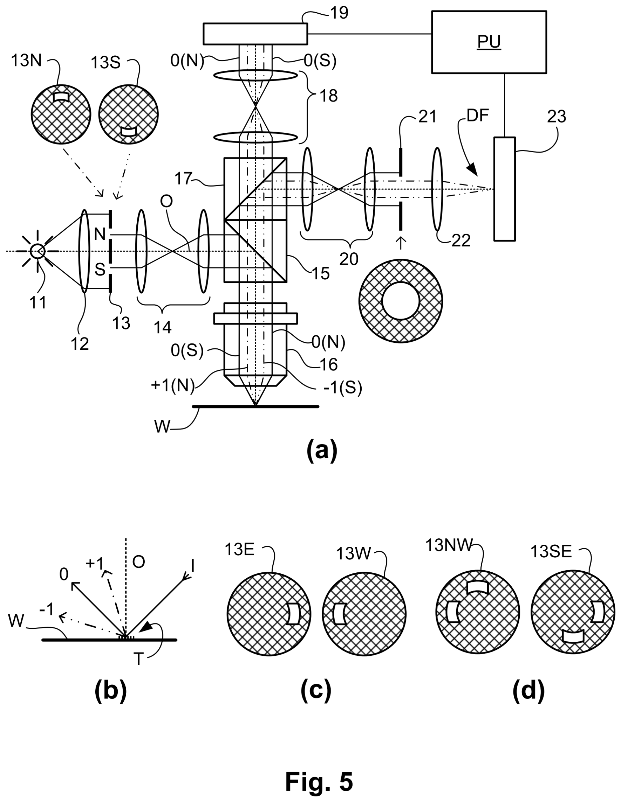

A metrology apparatus suitable for use in embodiments of the invention is shown in Figure 5(a). A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures, such as those which enable simultaneous illumination and detection from two opposing directions in combination with optical wedges to separate the resultant images. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

In particular, it is known to use a quartered aperture plate providing illumination in only two diagonally opposing quadrants of the illumination pupil. Such an illumination arrangement, in combination with suitable directing optics (e.g., a wedge arrangement) in the detection branch, enables simultaneous capture of +1 and -1 diffraction images of each of X and Y gratings in each of two substrate orientations (e.g., 0 and 180 degrees).

It is known to use an apparatus such as illustrated in Figure 5(a) to measure overlay. To achieve this, overlay targets may be printed on a wafer in two layers. One method of overlay metrology (sometimes referred to as micro-diffraction based overlay ($\mu$DBO)) infers overlay from an asymmetry imbalance in corresponding diffraction orders (normal and complementary diffraction orders such as +1 and -1 orders) from targets comprising a respective grating in each layer. Typically, in $\mu$DBO the gratings have the same single pitch in each layer, though there may be an imposed bias between the two targets.

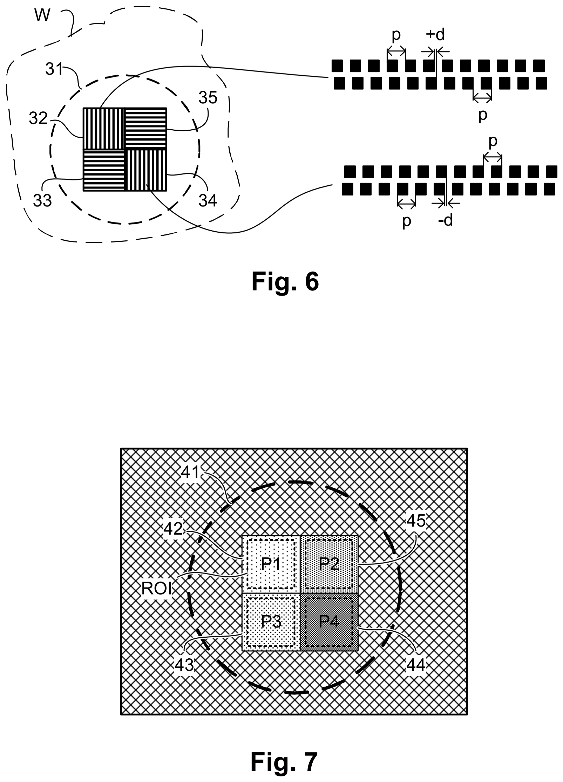

Figure 6 depicts an example (composite) $\mu$DBO target formed on a substrate W according to known practice. The target in this example comprises four sub-targets 32 to 35 (or target pads) positioned closely together so that they will all be within a measurement spot 31 formed by the metrology radiation illumination beam of the metrology apparatus, i.e. the target is overfilled. The four sub-targets, when measured with the apparatus of Figure 5, are all simultaneously illuminated and simultaneously imaged on sensors 19 and 23. In an example dedicated to measurement of overlay, sub-targets 32 to 35 are themselves composite gratings formed by overlying sub-gratings that are patterned in different layers of the semi-conductor device formed on substrate W. Sub-targets 32 to 35 may have differently biased overlay offsets in order to facilitate measurement of overlay between the layers in which the different parts of the composite sub-targets are formed. Sub-targets 32 to 35 having a pitch p may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively (not shown). Separate images of these sub-targets can be identified in the image captured by sensor 23. This is only one example of a target. A target may comprise more or fewer than 4 sub-targets, or only a single sub-target.

Figure 7 shows an example of an image that may be formed on and detected by the sensor 23, using the target of Figure 6 in the apparatus of Figure 5, using the aperture plates 13NW or 13SE from Figure 5(d). While the pupil plane image sensor 19 cannot resolve the different individual sub-targets 32 to 35, the image sensor 23 can do so. The dark rectangle represents the field of the image on the sensor, within which the illuminated spot 31 on the substrate (see Fig. 6) is imaged into a corresponding circular area 41. Within this, rectangular areas 42-45 represent the images of the sub-targets 32 to 35. If the targets are located in product areas, product features may also be visible in the periphery of this image field. Image processor and controller process these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the sub-targets have been identified, the intensities of those individual images can be measured, e.g., by averaging or summing selected pixel intensity values over a respective region of interest (ROI) within each of the identified images 42 to 45 of sub-targets 32 to 35. The ROI may comprise a central region P1, P2, P3, P4 of each image 42 to 45, away from the edges, for example. The measurement region that is ROI may be considered as an evaluation region: using the ROI intensities and/or other properties of the images can be compared with one another and these results can be combined to measure different parameters of the lithographic process. Overlay performance is an important example of such a parameter.

To determine the ROIs of each sub-target on a target image such as the image of Figure 7, typically the center of the target image is found such that separate target images (e.g., for at least a single measurement) can be aligned. Typically there are at least two, e.g., four (or more), separate target images per single measurement. These target images comprise normal and complementary images (typically a +1 diffraction order image and a -1 diffraction order image forming a pair of target images) for each of two substrate orientations (separated by 180 degrees, e.g., a 0 degree pair of +1, -1 images and a 180 degree pair of +1, -1 images). These images may be obtained in a two measurement capture series (e.g., respective captures at each of the substrate orientations). The reason for obtaining a pair of target images (e.g., +1 and -1 images) per substrate orientation is to mitigate, compensate and/or correct for optical irregularities or asymmetries of the metrology apparatus (i.e., the so-called tool-induced shift TIS).

It is important to align the images such that they can be properly compared. The parameter of interest (e.g., overlay) is determined by a comparison (e.g., a difference or ratio) of the normal and complementary images, averaged over the two substrate orientations. The best accuracy is achieved when the ROIs for each image properly correspond (i.e., each corresponding ROI from the respective target images all relate to the same region of the measured target). Typically, the target images are aligned to find their center using a pattern recognition algorithm. This may be done by comparing each target image to a reference template, which is a simple representation of a target, e.g., a target comprising four sub-targets arranged in the manner of a μDBO target.

The entire area of each sub-target (also known as a pad) is not useable for the ROI due to the effects that arise from illuminating a grating that is finite in size. These so-called edge effects can manifest themselves as bright edges that cause light leakage into the interior of the sub-target. This is detrimental for a method that relies on average intensities from these gratings. To minimize the effects of these edge effects, an edge exclusion is recommended to ensure that overlay measurements are reliable.

Currently, a preset 'all-around' edge exclusion is used (although other different edge exclusions may be flexibly defined and used). Optimizing this edge exclusion (i.e. an edge region to be excluded or removed to obtain a ROI) to improve accuracy, precision, or tool-to-tool matching is generally not done because it is too expensive timewise. At present, a user would need to try different settings on a metrology tool (e.g., the apparatus shown in Figure 5(a)), and for each setting evaluate the performance indicator (e.g., accuracy, precision, tool-to-tool matching, etc.) that the user is interested in improving so as to determine the optimal edge exclusion (and therefore the optimal ROI). This process is too costly. Just setting a very large edge exclusion to get rid of any edge effects or pattern recognition inaccuracies is also not feasible as the ROI area might become too small and the remaining measurement data dominated by photon shot noise.

In view of the more stringent performance requirements, methods according to the invention disclosed herein may comprise a method of determining a measurement region such as a region of interest, ROI. In the methods of the invention, signals are obtained from a plurality of metrology targets. These targets may be located at any location on a wafer, or even on separate wafers. The methods are not limited to neighboring targets located on the same wafer in the vicinity of each other. With reference to Figure 8, the proposed method 800 of determining a ROI comprises the following three main steps, i.e. 810-830 (steps 820 and 830 will be described in later paragraphs following the description of Figure 9).

Method step 810 comprises obtaining at least one variation map derived from signals of a plurality of metrology targets. These signals may be obtained from measurements of the plurality of targets and/or from simulations of the same. Each of the at least one variation map comprises a plurality of data points, each of which indicates a variation of a component of the signals collected from a corresponding location of the plurality of metrology targets. Therefore the variation map may be represented as a two-dimensional data map. The component of the signals is not indicative of a parameter of interest (e.g., not useful or desirable for determining a value of the parameter of interest). In the context of the present disclosure, a variation map may also be referred to as a nuisance map (or a noise map) which is a data file or image used to identify and optionally filter out recurring, patterns or variations that might otherwise be mistakenly used for determining a value of the parameter of interest. Accordingly, the component of thesignals that is not indicative of a parameter of interest may be the main contributor to such recurring patterns or variations. A method of determining at least a variation map will be described with respect to Fig. 9.

In an embodiment, the parameter of interest may be overlay. The metrology targets may be overlay targets, each comprising one or more first biased sub-targets (or target pads) with a first target bias and one or more second biased sub-targets with a second target bias. For example, each metrology target may be a μDBO target (e.g., the target in Figure 6) which may comprise a first X-direction sub-target with a positive bias (e.g., sub-target 32 in Figure 6 with positive bias +d) and a second X-direction sub-target with a negative bias (e.g., sub-target 34 in Figure 6 with negative bias -d). Such an example metrology target may further comprise a first Y-direction sub-target with a positive bias (e.g., sub-target 33 in Figure 6) and a second Y-direction sub-target with a negative bias (e.g., sub-target 35 in Figure 6). In such a case, the at least one variation map may comprise a first variation map comprising a plurality of first data points obtained for the positively biased X-direction sub-targets of a plurality of metrology targets and a second variation map comprising a plurality of second data points obtained for the negatively biased X-direction sub-targets of the plurality of metrology targets. Similarly, another two variation maps may be obtained respectively for the positively biased Y-direction sub-targets of the plurality of metrology targets and negatively biased Y-direction sub-targets of the plurality of metrology targets. The component of the signals that is not indicative of overlay may comprise zeroth diffraction order and/or any other non-desirable or non-useful higher (e.g., $2^{nd}$ or higher) diffraction orders scattered from the metrology targets, and/or stray light from the surroundings of the metrology apparatus on which the metrology targets are measured. For example, zeroth diffraction order combined with physical edges of the target may drive the presence of bright edges.

With reference to Figure 9, the at least one variation map may be determined using a method comprising the following six main steps, i.e. 910-960.

Method step 910 may comprise obtaining $+1^{st}$ diffraction order images and $-1^{st}$ diffraction order images of the first biased sub-targets or the second biased sub-targets. In an embodiment, the step of obtaining individual, separate $+1^{st}$ diffraction order images and $-1^{st}$ diffraction order images of the first biased sub-targets or the second biased sub-targets may comprise 1) obtaining $+1^{st}$ diffraction order images and $-1^{st}$ diffraction order images of the plurality of metrology targets; 2) determining at least one reference location (e.g., a center location or a corner location) of each of the $+1^{st}$ diffraction order images and $-1^{st}$ diffraction order images using a pattern recognition technique; 3) determining individual (e.g., rectangular) areas of the first biased sub-targets and the second biased sub-targets in the $+1^{st}$ diffraction order images and $-1^{st}$ diffraction order images of each metrology target (e.g., the rectangular areas 42-45 representing the images of the sub-targets 32 to 35 in Figure 7) based on the determined at least one reference location; and 5) separating (or cutting out) the individual (e.g., rectangular) areas of the first biased sub-targets and the second biased sub-targets from the $+1^{st}$ diffraction order images and $-1^{st}$ diffraction order images of the plurality of metrology targets to obtain the $+1^{st}$ diffraction order images and $-1^{st}$ diffraction order images of the first biased sub-targets or the second biased sub-targets. For example, referring back to Figure 7, after the rectangular areas 42-45 of the sub-targets (e.g., sub-targets 32-35 shown in Figure 6) are separated (or cut out) from the original image and from each other, such rectangular areas become separate $+1^{st}$ or $-1^{st}$ diffraction order images of the respective sub-targets.

It will be appreciated that the at least one reference location (e.g., a center location or a corner location) of each of the $+1^{st}$ diffraction order images and $-1^{st}$ diffraction order images may be determined without using a pattern recognition technique. For example, the center location of each image may be determined manually e.g., by measuring the dimensions of the metrology target in each image. The accuracy of such a manual determination may be limited.

Method step 920 may comprise subtracting first mean intensity values respectively from the $+1^{st}$ diffraction order images so as to obtain processed $+1^{st}$ diffraction order images, when the mean intensity values indicate an average value of the parameter of interest of the image (e.g., overlay)).Each of the first mean intensity values may be determined by calculating a mean intensity value of a default ROI of a respective one of the $+1^{st}$ diffraction order images.

Method step 930 may comprise subtracting second mean intensity values respectively from the $-1^{st}$ diffraction order images so as to obtain processed $-1^{st}$ diffraction order images, when the mean intensity values indicate an average value of the parameter of interest of the image (e.g., overlay)). Each of the second mean intensity values may be determined by calculating a mean intensity value of a default ROI of a respective one of the $-1^{st}$ diffraction order images.

By defining a default ROI, a cleaner or more accurate mean intensity value may be calculated for each diffraction order image (e.g not accounting for bright edge effects). For both steps 920 and 930, the default ROI of each of the $+1^{st}$ diffraction order images or the $-1^{st}$ diffraction order images may be obtained by excluding or removing a predefined edge region of the corresponding image, such as the ROIs P1-P4 shown in Figure 7. The shape and dimensions of the excluded edge region may be determined e.g., based on historical (measured or simulated) data. This default ROI of each diffraction order image of a biased sub-target may be used as a starting ROI for determining initial conditions of an optimization process which may lead to an optimal ROI (see method step 820 below for more details). Although it may be more likely that the default ROI may cover an area that is smaller than the entire area of a diffraction order image of a sub-target or pad (e.g., in order to remove bright edge effects), it may also be possible that the default ROI covers the entire area of the diffraction order image.

For both steps 920 and 930, after removing a mean intensity (which may indicate an average value of the parameter of interest of the image (e.g., overlay)) from each image, the intensity of each pixel of the resultant processed diffraction order image may represent the intensity of the component of the signals, which is not indicative of the parameter of interest (e.g., not useful or desirable for determining overlay), collected from the corresponding location of the corresponding sub-target. In an example implementation (e.g., in the case of μDBO targets), the mean intensity of the default ROI of each diffraction order image may be obtained by using a weighted average over the default ROI of the image. A weighting mask may be defined to assign for example a low confidence rating to an edge region (which may be deemed to be less reliable) and a high confidence rating to a central region of the default ROI of the corresponding image.

Method step 940 may comprise subtracting the processed +1st diffraction order images from the corresponding processed -1st diffraction order images, or vice versa, to obtain asymmetry images of the first biased sub-targets or the second biased sub-targets. The process of obtaining asymmetry images $A_+$, $A_-$ is illustrated in Fig. 10(a) and 10(b). Methods steps 950 to 960 of Fig. 9 will be explained in later paragraphs following the description of Fig. 10(a) and 10(b).

With reference to Figures 10(a) and 10(b), and as previously described with respect to Fig. 9 in step 910, once separated from the original images of the metrology targets, there may be four images associated with the X-direction sub-targets, i.e. one positive +1st diffraction order image PPB and one negative -1st diffraction order image NPB of the positively biased X-direction sub-target (e.g., sub-target 32 in Figure 6), and one positive +1st diffraction order image PNB and one negative -1st diffraction order image NNB of the negatively biased X-direction sub-target (e.g., sub-target 34 in Figure 6), as well as four images (not shown) associated with the Y-direction sub-targets, i.e. one positive +1st diffraction order image and one negative -1st diffraction order image of the positively biased Y-direction sub-target (e.g., sub-target 33 in Figure 6), and one positive +1st diffraction order image and one negative -1st diffraction order image of the negatively biased Y-direction sub-target (e.g., sub-target 35 in Figure 6). Subtracting the image NPB from the image PPB (or vice versa) to obtain asymmetry images of each sub-target may result in a first asymmetry image $A_+$ for the positively biased sub-target while subtracting the image NNB from the image PNB may result in a second asymmetry image $A_-$ for the negatively biased sub-target. The images associated with the Y-direction sub-targets may be processed in the same manner as the X-direction images and will not be repeated here for the sake of simplicity. As such, for each metrology target, there may be two asymmetry images for the X-direction sub-targets (one for each bias, +d, -d) and two asymmetry images for the Y-direction sub-targets (one for each bias, +d, -d).

Therefore, as shown in Figure 10(c), processing images of a plurality of metrology targets may result in a plurality of pairs of asymmetry images $A_+$, $A_-$ for each (X or Y) direction, each pair of asymmetry images comprising a first asymmetry image $AM1\_A_+$, $AM2\_A_+$, or $AM3\_A_+$ (e.g., obtained for the positively biased X-direction sub-target of a corresponding metrology target 1, 2 or 3) and a second asymmetry image $AM1\_A_-$, $AM2\_A_-$, or $AM3\_A_-$ (e.g., obtained for the negatively biased X-direction sub-target of the same metrology target 1, 2 or 3). Although asymmetry images are only illustrated for a set of three metrology targets, the plurality of targets may comprise alternatively data for only two targets, or four or more targets.

Method step 950 may comprise determining, for every pixel of the asymmetry images, a pixel-wise intensity variation of the asymmetry images. By way of example and with continued reference to Figure 10(c), each of the first asymmetry images $AM1\_A_+$, $AM2\_A_+$, $AM3\_A_+$, or the second asymmetry images $AM1\_A_-$, $AM2\_A_-$, $AM3\_A_-$, may comprise a matrix of pixels (e.g., N pixels along the X-direction and M pixels along the Y-direction), wherein each pixel may have an intensity value indicating an intensity asymmetry of the component of thesignals collected from the corresponding location of the sub-target of target 1 to 3. As shown in Figure 10(c), the pixels, e.g., P1_11, P2_11, and P3_11, at the top left corner of the first asymmetry images $AM1\_A_+$, $AM2\_A_+$, $AM3\_A_+$ may be used to determine an intensity variation (e.g., a standard deviation of the pixel intensities) for the corresponding location of the positively biased (e.g., X-direction) sub-target of target 1 to 3. Similarly, the pixels, e.g., P1_1N, P2_1N, P3_1N, at the top right corner of the first asymmetry images $AM1\_A_+$, $AM2\_A_+$, $AM3\_A_+$ may be used to determine an intensity variation (e.g., a standard deviation of the pixel intensities) for the corresponding location of the positively biased (e.g., X-direction) sub-target of target 1 to 3. The same process may be applied to every set of corresponding pixels of the first asymmetry images so as to obtain a first M x N matrix of data points, each data point, e.g., V11, ...or V1N, indicating an intensity variation of the pixels at the corresponding location, e.g., P1_11 to P3_11, ... or P1_1N to P3_1N. A second M x N matrix of data points may be similarly obtained for the second asymmetry images $AM1\_A_-$, $AM2\_A_-$, $AM3\_A_-$.

Method step 960 may comprise generating the variation map using the determined pixel-wise variations. Continuing with the above example and with reference to Figure 10(d), the first M x N matrix of data points, e.g., V11...VMN, determined based on the first asymmetry images $AM1\_A_+$, $AM2\_A_+$, $AM3\_A_+$ may be used to generate a first variation map $VM\_A+$ and the second M x N matrix of data points (not shown) determined based on the second asymmetry images $AM1\_A_-$, $AM2\_A_-$, $AM3\_A_-$ may be used to generate a second variation map $VM\_A-$. The first and second variation maps $VM\_A+$ and $VM\_A-$ may be used for defining a cost function at method step 820 (see below). Similarly to what is described in relation to Fig. 10(c) with asymmetry images, the variation maps may alternatively be generated based on set of first asymmetry images or a set of second asymmetry images comprising a different number (i.e. a number other than three) of images.

Method step 820 comprises defining a cost function for optimizing a ROI in images of the plurality of metrology targets, wherein the cost function comprises a first term relating to a variation of the data points whose corresponding locations of the metrology targets falling within a default ROI, and a second term relating to an impact of a size of the default ROI on measurement repeatability. The default ROI of the images of a biased sub-target may be predefined (e.g., based on an existing edge exclusion method) and used as a starting ROI for determining initial conditions (e.g., a mean intensity of the ROI of an image) for the cost function. The default ROI may be equal to or smaller than the entire area of the diffraction order image.

In an embodiment, the optimal ROI may be determined by minimizing the cost function. The cost function may use the default ROI.

The first term of the cost function may be determined from a first sum of a first variation of the first data points of the first variation map scaled by a first scaling factor and a second variation of the second data points of the second variation map scaled by a second scaling factor. The first variation and the second variation may be both standard deviations of the corresponding data points. The first term may be further determined from a cubic root of the first sum.

The first scaling factor may be based on a ratio of: a second average asymmetry relating to the second biased sub-targets and a difference of the second average asymmetry relating to the second biased sub-targets and first average asymmetry relating to the first biased sub-targets. The first scaling factor may be further based on the ratio scaled by minus twice the first target bias. The second scaling factor may be based on a ratio of: the first average asymmetry relating to the first biased sub-targets and a difference of the second average asymmetry relating to the second biased sub-targets and first average asymmetry relating to the first biased sub-targets. The second scaling factor may be further based on the ratio scaled by twice the second target bias.

The second term of the cost function may be determined from a second sum of: a square of a first intensity noise (e.g., $\sigma_{I_{PBN}}^2$ in equation [3] below) of a first component (e.g., +1st diffraction order intensity signal $I_{PBN}$ from the positively biased X sub-target, see equations [3] and [4] below) of the signals scaled by a first coefficient, a square of a second intensity noise (e.g., $\sigma_{I_{PBC}}^2$ in equation [3] below) of a second component (e.g., -1st diffraction order intensity signal $I_{PBC}$ from the positively biased X sub-target, see equations [3] and [4] below) of the signals scaled by a second coefficient, a square of a third intensity noise (e.g., $\sigma_{I_{NBN}}^2$ in equation [3] below) of a third component (e.g., +1st diffraction order intensity signal $I_{NBN}$ from the negatively biased X sub-target, see equations [3] and

[0079] [4] below) of the signals scaled by a third coefficient, and a square of a fourth intensity noise (e.g., $\sigma_{I_{NBC}}^2$ in equation [3] below) of a fourth component (e.g., -1st diffraction order intensity signal $I_{NBC}$ of the negatively biased X sub-target, see equations [3] and [4] below) of the signals scaled by a fourth coefficient, the first component and the second component being from opposite diffraction orders and associated with the first biased sub-targets, and the third component and the fourth component being from opposite diffraction orders and associated with the second biased sub-targets. The second term of the cost function may be further determined from a cubic root of the second sum. The first component of the signals may comprise +1st diffraction order signals from the first biased sub-targets. The second component of the signals may comprise -1st diffraction order signals from the first biased sub-targets. The third component of the signals may comprise +1st diffraction order signals from the second biased sub-targets. The fourth component of the signals may comprise -1st diffraction order signals from the second biased sub-targets.

The first coefficient may be based on a square of a partial derivative of overlay with respect to intensity of the first component of the signals (e.g., $\left(\frac{\partial OV}{\partial I_{PBN}}\right)^2$ in equation [3] below). The second coefficient may be based on a square of a partial derivative of overlay with respect to intensity of the second component of the signals (e.g., $\left(\frac{\partial OV}{\partial I_{PBC}}\right)^2$ in equation [3] below). The third coefficient (e.g., $\left(\frac{\partial OV}{\partial I_{NBN}}\right)^2$ in equation [3] below) may be based on a square of a partial derivative of overlay with respect to intensity of the third component of the signals. The fourth coefficient (e.g., $\left(\frac{\partial OV}{\partial I_{NBC}}\right)^2$ in equation [3] below) may be based on a square of a partial derivative of overlay with respect to intensity of the fourth component of the signals.

In an example implementation, the cost function for an edge exclusion parameter **EE**, which indicates a size (e.g., width) of the edge to be excluded from an image (e.g., PPB, NPB, PNB, NNB shown in Figures 10(a) and 10(b)) of a sub-target in order to obtain a ROI of the image, may be defined as:

$$\widehat{EE} = argmin\left[f(I_{n\pm}(EE),\, AA_\pm) + \alpha * g(A(EE), I_0,\, SS)\right]. \qquad [1]$$

The first term $f(I_{n\pm}(EE),\, AA_\pm)$ of the cost function [1] may be expressed as:

$$f(I_{n\pm}(EE), AA_\pm) = 3\sqrt{\left(-2d\frac{AA_-}{AA_- - AA_+}\right)^2 \sigma_{AA_+}^2 + \left(2d\frac{AA_+}{AA_- - AA_+}\right)^2 \sigma_{AA_-}^2}\,, \qquad [2]$$

where $\sigma_{AA+}^2$ is the variation of data points of the variation map $I_{n+}(\mathbf{EE})$ obtained for the positively biased sub-targets and $\sigma_{AA-}^2$ is the variation of data points of the variation map $I_{n-}(\mathbf{EE})$ obtained for the negatively biased sub-targets; $AA_+$ is the mean/average asymmetry of all the positively biased sub-targets on the wafer (e.g., the average of all the asymmetry images $AM1\_A_+, AM2\_A_+, AM3\_A_+$ shown in Figure 10(c)) and $AA_-$ is the mean/average asymmetry of all the negatively biased sub-targets on the wafer (e.g., the average of all the asymmetry images $AM1\_A_-, AM2\_A_-, AM3\_A_-$ shown in Figure 10(c)); $d$ is the amount of the bias of the positively or negatively biased sub-targets. In an embodiment, the variations $\sigma_{A+}^2, \sigma_{A-}^2$ may be (weighted) standard deviations of the data points of the respective variation maps $I_{n+}(\mathbf{EE}), I_{n-}(\mathbf{EE})$. The first term of the cost function quantifies the uncertainty in the parameter of interest (e.g overlay) measurement caused by the intra-ROI variation, meaning how much the signal asymmetries fluctuate due to noise, process variation, or other systematic effects. Minimizing this term helps ensure that the measurement is robust and not overly affected by local disturbances or artifacts.

The second term $g(A(\mathbf{EE}), I_0, SS)$ of the cost function [1] may be expressed as:

$$g(A(\mathbf{EE}), I_0, SS) = 3\sqrt{\left(\frac{\partial OV}{\partial I_{PBN}}\right)^2 \sigma_{I_{PBN}}^2 + \left(\frac{\partial OV}{\partial I_{PBC}}\right)^2 \sigma_{I_{PBC}}^2 + \left(\frac{\partial OV}{\partial I_{NBN}}\right)^2 \sigma_{I_{NBN}}^2 + \left(\frac{\partial OV}{\partial I_{NBC}}\right)^2 \sigma_{I_{NBC}}^2}, \quad [3]$$

where the first parameter $A(\mathbf{EE})$ denotes the area of the ROI after applying edge exclusion (i.e the default ROI) according to $\mathbf{EE}$; the second parameter $I_0$ denotes the mean/average intensity of all the (+1st diffraction order and -1st diffraction order) images of the (positively and negatively) biased sub-targets for a given overlay (X or Y) direction; the third parameter $SS$ denotes the mean stack sensitivity over all the measured targets and is a unitless parameter indicating the sensitivity of the measured asymmetries to a change in overlay; $\sigma_{IPBN}$ denotes an intensity noise of the +1st diffraction order intensity signal $I_{PBN}$ from the positively biased X sub-target; $\sigma_{IPBC}$ denotes an intensity noise of the - 1st diffraction order intensity signal $I_{NBN}$ from the positively biased X sub-target; $\sigma_{INBN}$ denotes an intensity noise of the +1st diffraction order intensity signal $I_{PBC}$ from the negatively biased X sub-target; and $\sigma_{INBC}$ denotes an intensity noise of the -1st diffraction order intensity signal $I_{NBC}$ of the negatively biased X sub-target. The second term of the cost function represents the expected impact on measurement precision as a function of ROI size. It penalizes ROI configuration choices (such as making the ROI excessively small, which reduces photon count and increases noise) that would reduce the repeatability of the measurement under the same conditions, or the consistency of the resulting parameter of interest when repeating the measurement multiple times on the same target. Minimizing this term helps ensure there is sufficient data and signal quality for a precise measurement. The above parameters may be used to determine an approximate intensity level $\vec{I}$ for four signals from the biased sub-targets, i.e. an approximate intensity $I_{PBN}$ of +1st diffraction order signal from the positively biased X sub-target, an approximate intensity $I_{PBC}$ of -1st diffraction order signal from the positively biased X sub-target, an approximate intensity $I_{NBN}$ of +1st diffraction order signal from the negatively biased X sub-target, and an approximate intensity $I_{NBC}$ of -1st diffraction order signal of the negatively biased X sub-target. The approximate intensity $\vec{I}$ may be expressed as:

$$\vec{I} = \begin{pmatrix} I_{PBN} \\ I_{PBC} \\ I_{NBN} \\ I_{NBC} \end{pmatrix} = \begin{pmatrix} I_0 + \frac{I_0 SS(x+d)}{2d} \\ I_0 - \frac{I_0 SS(x+d)}{2d} \\ I_0 + \frac{I_0 SS(x-d)}{2d} \\ I_0 - \frac{I_0 SS(x-d)}{2d} \end{pmatrix}, \quad [4]$$

where $d$ is the amount of the bias of the biased sub-targets and $x$ is the overlay value for which we would want to know the four intensities.

A noise model h(.) may then be used to calculate the uncertainty per intensity (or the intensity noise over the area of the ROI of each of the above-mentioned four images) using the area and intensity vector that was previously determined:

$$h(\vec{I}, A(\mathbf{EE})) = \begin{pmatrix} \sigma_{I_{PBN}} \\ \sigma_{I_{PBC}} \\ \sigma_{I_{NBN}} \\ \sigma_{I_{NBC}} \end{pmatrix}. \quad [5]$$

The partial derivatives in $g(A(\mathbf{EE}), I_0, SS)$, i.e. $\frac{\partial OV}{\partial I_{PBN}}, \frac{\partial OV}{\partial I_{PBC}}, \frac{\partial OV}{\partial I_{NBN}}$, and $\frac{\partial OV}{\partial I_{NBC}}$, may be determined by:

$$\begin{pmatrix} \frac{\partial OV}{\partial I_{PBN}} \\ \frac{\partial OV}{\partial I_{PBC}} \\ \frac{\partial OV}{\partial I_{NBN}} \\ \frac{\partial OV}{\partial I_{NBC}} \end{pmatrix} = \begin{pmatrix} -\frac{x-d}{2I_0 SS} \\ \frac{x-d}{2I_0 SS} \\ \frac{x+d}{2I_0 SS} \\ -\frac{x+d}{2I_0 SS} \end{pmatrix}, \qquad [6]$$

which may stem from the simplified equation for overlay $OV$ calculation: $OV = d\frac{A_+ - A_-}{A_+ + A_-}$, where $A_+ = I_{PBN} - I_{PBC}$ and $A_- = I_{NBN} - I_{NBC}$.

Typically, the second term may result in a value (e.g., on the order of nanometers) significantly smaller than that (e.g., on the order of micrometers) of the first term. Therefore, a balance parameter $\alpha$ may be used to scale the second term so as to obtain a right balance between the first term and the second term. The balance parameter $\alpha$ may be in the range of between 0 to 1000, between 0 and 500, between 0 and 200, or between 0 and 100.

Method step 830 comprises using the cost function to determine the ROI of the images. Preferably, the ROI of the images may be determined by minimizing the cost function (e.g., cost function [1]).

As described above, a suitable pattern recognition technique (e.g., a pattern recognition algorithm) may be used to determine one or more variation maps for use in determining a ROI in optical metrology. However, there lacks a method of selecting an optimal pattern recognition technique for each layer and/or measurement profile in optical metrology (e.g., overlay metrology). Determining an optimal pattern recognition technique may typically require 1) manually creating special measurement recipes where multiple pattern recognition algorithms are used; 2) running these measurement recipes on a metrology tool to obtain measurement data; and 3) analyzing the measurement data to determine which pattern recognition algorithm results in a desired performance. This process is too time-consuming. It is thus desirable to provide a method that is able to improve the efficiency of the above process.

Accordingly, another aspect of the present disclosure may provide a method of selecting a suitable pattern recognition technique for use in the foregoing embodiments of the proposed methods 800 and 900. The method uses variation maps (or nuisance maps) to achieve automatic pattern recognition algorithm selection. Each variation map may be determined in the same manner as described above in relation to method 900.

With reference to Figure 11, in an embodiment, the method 1100 may comprise the following three main steps, 1110-1130.

Method step 1110 may comprise obtaining a plurality of variation maps using a plurality of pattern recognition techniques, respectively.

Method step 1120 may comprise determining a variation (e.g., a standard deviation) of data points of each of the plurality of variation maps so as to obtain a plurality of variations.

Method step 1130 may comprise selecting a pattern recognition technique from the plurality of pattern recognition techniques based on the determined plurality of variations.

In an embodiment, the pattern recognition technique may be selected if its corresponding variation is minimum among the plurality of variations.

Another different aspect of the present disclosure may provide a computer program comprising program instructions operable to perform the proposed methods 800, 900, and 1100, when run on a processor-controlled apparatus (e.g., a processing unit of a metrology apparatus).

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance. The breadth and scope of the present invention should not be limited by any of the above-described exemplary embodiments, but should be defined only in accordance with the following claims and their equivalents.

Further embodiments of the invention are described in numbered clauses below:

1. A method of determining a measurement region, comprising:

obtaining at least one variation map derived from signals of a plurality of metrology targets, wherein the at least one variation map each comprises a plurality of data points, each data point indicating a variation of a component of the signals collected from a corresponding location of the plurality of metrology targets and the component of the signals not being indicative of a parameter of interest;

defining a cost function for optimizing a measurement region in images of the plurality of metrology targets, wherein the cost function comprises a first term relating to a variation of the plurality of data points whose corresponding locations of the metrology targets falling within a default measurement region of the at least one variation map, and a second term relating to an impact of a size of the default measurement region on measurement repeatability; and

using the cost function to determine the measurement region of the images.

2. A method as defined in clause 1, wherein the measurement region is determined by minimizing the cost function.

3. A method as defined in clause 1 or 2, wherein the measurement region is a region of interest, ROI, for parameter of interest inference.

4. A method as defined in any preceding clause, wherein the parameter of interest is overlay.

5. A method as defined in any preceding clause, wherein the signals of the plurality of metrology targets comprise images of the targets measured by an image plane sensor.

6. A method as defined in any preceding clause, wherein each of the plurality of metrology targets comprises one or more first biased sub-targets with a first target bias and one or more second biased sub-targets with a second target bias.

7. A method as defined in clause 6, wherein the at least one variation map comprises a first variation map comprising a plurality of first data points obtained for the first biased sub-targets and a second variation map comprising a plurality of second data points obtained for second biased sub-targets.

8. A method as defined in clause 7, wherein the first term of the cost function is determined from a first sum of a first variation of the first data points of the first variation map scaled by a first scaling factor and of a second variation of the second data points of the second variation map scaled by a second scaling factor.

9. A method as defined in clause 8, wherein the first variation is a first standard deviation, and the second variation is a second standard deviation.

10. A method as defined in clause 8 or 9, wherein the first term of the cost function is determined from a cubic root of the first sum.

11. A method as defined in any of clauses 8 to 10, wherein the first scaling factor is based on a ratio of a second average asymmetry relating to the second biased sub-targets and a difference of the second average asymmetry relating to the second biased sub-targets and first average asymmetry relating to the first biased sub-targets.

12. A method as defined in clause 11, wherein the first scaling factor is based on the ratio scaled by minus twice the first target bias.

13. A method as defined in any of clauses 8 to 12, wherein the second scaling factor is based on a ratio of the first average asymmetry relating to the first biased sub-targets and a difference of the second average asymmetry relating to the second biased sub-targets and first average asymmetry relating to the first biased sub-targets.

14. A method as defined in any of clauses 8 to 13, wherein the second scaling factor is based on the ratio scaled by twice the second target bias.

15. A method as defined in any of clauses 7 to 14, wherein the second term of the cost function is determined from a second sum of a square of a first intensity noise of a first component of the signals scaled by a first coefficient, a square of a second intensity noise of a second component of the signals scaled by a second coefficient, a square of a third intensity noise of a third component of the signals scaled by a third coefficient, and a square of a fourth intensity noise of a fourth component of the signals scaled by a fourth coefficient, the first component and the second component being from opposite diffraction orders and associated with the first biased sub-targets, and the third component and the fourth component being from opposite diffraction orders and associated with the second biased sub-targets.

16. A method as defined in clause 15, wherein the first coefficient is based on a square of a partial derivative of overlay with respect to intensity of the first component of the signals, the second coefficient is based on a square of a partial derivative of overlay with respect to intensity of the second component of the signals, the third coefficient is based on a square of a partial derivative of overlay with respect to intensity of the third component of the signals, the fourth coefficient is based on a square of a partial derivative of overlay with respect to intensity of the fourth component of the signals.

17. A method as defined in clause 15 or 16, wherein the second term of the cost function is determined from a cubic root of the second sum.

18. A method as defined in any of clauses 15 to 17, wherein the first component of the signals comprises +1st diffraction

order signals from the first biased sub-targets, the second component of the signals comprises -1st diffraction order signals from the first biased sub-targets, the third component of the signals comprises +1st diffraction order signals from the second biased sub-targets, and the fourth component of the signals comprises -1st diffraction order signals from the second biased sub-targets.

19. A method as defined in any of clauses 7 to 18, wherein each of the at least one variation map is obtained by:

obtaining +1st diffraction order images and -1st diffraction order images of the first biased sub-targets or the second biased sub-targets;
subtracting first mean intensity values respectively from the +1st diffraction order images so as to obtain processed +1st diffraction order images;
subtracting second mean intensity values respectively from the -1st diffraction order images so as to obtain processed -1st diffraction order images;
subtracting the processed +1st diffraction order images from the corresponding processed -1st images, or vice versa, to obtain asymmetry images of the first biased sub-targets or the second biased sub-targets;
determining, for every pixel of the asymmetry images, a pixel-wise intensity variation of the asymmetry images; and
generating the variation map using the determined pixel-wise variations.

20. A method as defined in clause 19, wherein each of the first mean intensity values is determined by calculating a mean intensity value of the default measurement region of a respective one of the +1st diffraction order images, and each of the second mean intensity values is determined by calculating a mean intensity value of the default measurement region of a respective one of the -1st diffraction order images.

21. A method as defined in clause 20, wherein the default measurement region of each of the +1st diffraction order images or the -1st diffraction order images is obtained by excluding a predefined edge region of the corresponding image.

22. A method as defined in any of clauses 19 to 21, wherein the step of obtaining +1st diffraction order images and -1st diffraction order images of the first biased sub-targets or the second biased sub-targets comprises:

obtaining +1st diffraction order images and -1st diffraction order images of the plurality of metrology targets;
determine a center location of each of the +1st diffraction order images and -1st diffraction order images using a pattern recognition technique;
determining individual regions of the first biased sub-targets and the second biased sub-targets in the +1st diffraction order images and -1st diffraction order images; and
separating the individual regions of the first biased sub-targets and the second biased sub-targets to obtain the +1st diffraction order images and -1st diffraction order images of the first biased sub-targets or the second biased sub-targets.

23. A method as defined in clause 22, further comprising:

obtaining a plurality of variation maps using a plurality of pattern recognition techniques, respectively;
determining a variation of data points of each of the plurality of variation maps so as to obtain a plurality of variations; and
selecting a pattern recognition technique from the plurality of pattern recognition techniques based on the determined plurality of variations.

24. A method as defined in clause 23, wherein the pattern recognition technique is selected if its corresponding variation is minimum among the plurality of variations.

25. A method of selecting a pattern recognition technique for use in determining a measurement region, comprising:

obtaining a plurality of variation maps using a plurality of pattern recognition techniques, respectively;
determining a variation of data points of each of the plurality of variation maps so as to obtain a plurality of variations; and
selecting a pattern recognition technique from the plurality of pattern recognition techniques based on the determined plurality of variations.

26. A method as defined in clause 25, wherein the measurement region is a region of interest, ROI, for parameter of interest inference.

27. A method as defined in clause 25 or 26, wherein each of the at least one variation map is obtained by:

obtaining +1st diffraction order images and -1st diffraction order images of the first biased sub-targets or the second biased sub-targets;

subtracting first mean intensity values respectively from the +1st diffraction order images so as to obtain processed +1st diffraction order images;

subtracting second mean intensity values respectively from the -1st diffraction order images so as to obtain processed -1st diffraction order images;

subtracting the processed +1st diffraction order images from the corresponding processed -1st images, or vice versa, to obtain asymmetry images of the first biased sub-targets or the second biased sub-targets;

determining, for every pixel of the asymmetry images, a pixel-wise intensity variation of the asymmetry images; and

generating the variation map using the determined pixel-wise variations.

28. A method as defined in clause 27, wherein the step of obtaining +1st diffraction order images and -1st diffraction order images of the first biased sub-targets or the second biased sub-targets comprises:

obtaining +1st diffraction order images and -1st diffraction order images of the plurality of metrology targets;

determining a center location of each of the +1st diffraction order images and -1st diffraction order images using one of the plurality of pattern recognition techniques;

determining individual regions of the first biased sub-targets and the second biased sub-targets in the +1st diffraction order images and -1st diffraction order images; and

separating the individual regions of the first biased sub-targets and the second biased sub-targets to obtain the +1st diffraction order images and -1st diffraction order images of the first biased sub-targets or the second biased sub-targets.

29. A computer program comprising program instructions operable to perform the method of any preceding clause, when run on a processor-controlled apparatus.

30. A non-transient computer program carrier comprising the computer program of clause 29.

31. A processing arrangement comprising:

a non-transient computer program carrier comprising a computer program comprising program instructions operable to perform the method of any of clauses 1 to 28, when run on a suitable apparatus; and

a processor operable to run the computer program comprised on the non-transient computer program carrier.

32. A metrology apparatus comprising the processing arrangement of clause 31.

33. A metrology apparatus as defined in clause 32, comprising a scatterometer apparatus.

34. A metrology apparatus as defined in clause 32 or 33, comprising a dark-field scatterometer apparatus.

35. A metrology apparatus as defined in clause 32, 33, or 34 comprising:

a support for a substrate;

an optical system for illuminating a target on the substrate with measurement radiation; and

a detector for detecting the measurement radiation scattered by the target to capture target images.

36. A lithographic apparatus comprising the metrology apparatus as defined in any of clauses 32 to 35.

**Claims**

1. A method of determining a measurement region, comprising:

obtaining at least one variation map derived from signals of a plurality of metrology targets, wherein the at least one variation map each comprises a plurality of data points, each data point indicating a variation of a component of the signals collected from a corresponding location of the plurality of metrology targets and the component of the signals not being indicative of a parameter of interest;

defining a cost function for optimizing a measurement region in images of the plurality of metrology targets, wherein the cost function comprises a first term relating to a variation of the plurality of data points whose corresponding locations of the metrology targets falling within a default measurement region of the at least one variation map, and a second term relating to an impact of a size of the default measurement region on measurement repeatability; and

using the cost function to determine the measurement region of the images.

2. A method as claimed in claim 1, wherein the measurement region is determined by minimizing the cost function.

3. A method as claimed in claim 1 or 2, wherein the measurement region is a region of interest, ROI, for parameter of interest inference.

4. A method as claimed in any preceding claim, wherein the parameter of interest is overlay.

5. A method as claimed in any preceding claim, wherein the signals of a plurality of metrology targets comprise images of the targets measured by an image plane sensor.

6. A method as claimed in any preceding claim, wherein each of the plurality of metrology targets comprises one or more first biased sub-targets with a first target bias and one or more second biased sub-targets with a second target bias.

7. A method as claimed in claim 6, wherein the at least one variation map comprises a first variation map comprising a plurality of first data points obtained for the first biased sub-targets and a second variation map comprising a plurality of second data points obtained for the second biased sub-targets.

8. A method as claimed in claim 7, wherein the first term of the cost function is determined from a first sum of a first variation of the first data points of the first variation map scaled by a first scaling factor and of a second variation of the second data points of the second variation map scaled by a second scaling factor.

9. A method as claimed in claim 7 or 8, wherein the second term of the cost function is determined from a second sum of a square of a first intensity noise of a first component of the signals scaled by a first coefficient, a square of a second intensity noise of a second component of the signals scaled by a second coefficient, a square of a third intensity noise of a third component of the signals scaled by a third coefficient, and a square of a fourth intensity noise of a fourth component of the signals scaled by a fourth coefficient, the first component and the second component being from opposite diffraction orders and associated with the first biased sub-targets, and the third component and the fourth component being from opposite diffraction orders and associated with the second biased sub-targets.

10. A method as claimed in any of claims 6 to 8, wherein each of the at least one variation map is obtained by:

   obtaining $+1^{st}$ diffraction order images and $-1^{st}$ diffraction order images of the first biased sub-targets or the second biased sub-targets;
   subtracting first mean intensity values respectively from the $+1^{st}$ diffraction order images so as to obtain processed $+1^{st}$ diffraction order images;
   subtracting second mean intensity values respectively from the $-1^{st}$ diffraction order images so as to obtain processed $-1^{st}$ diffraction order images;
   subtracting the processed $+1^{st}$ diffraction order images from the corresponding processed $-1^{st}$ images, or vice versa, to obtain asymmetry images of the first biased sub-targets or the second biased sub-targets;
   determining, for every pixel of the asymmetry images, a pixel-wise intensity variation of the asymmetry images; and
   generating the variation map using the determined pixel-wise variations.

11. A method as claimed in claim 10, wherein each of the first mean intensity values is determined by calculating a mean intensity value of the default measurement region of a respective one of the $+1^{st}$ diffraction order images, and each of the second mean intensity values is determined by calculating a mean intensity value of the default measurement region of a respective one of the $-1^{st}$ diffraction order images.

12. A method as claimed in claim 11, wherein the default measurement region of each of the $+1^{st}$ diffraction order images or the $-1^{st}$ diffraction order images is obtained by excluding a predefined edge region of the corresponding image.

13. A method as claimed in any of claims 10 to 12, wherein the step of obtaining $+1^{st}$ diffraction order images and $-1^{st}$ diffraction order images of the first biased sub-targets or the second biased sub-targets comprises:

   obtaining $+1^{st}$ diffraction order images and $-1^{st}$ diffraction order images of the plurality of metrology targets;
   determine a location of each of the $+1^{st}$ diffraction order images and $-1^{st}$ diffraction order images using a pattern recognition technique;

determining individual regions of the first biased sub-targets and the second biased sub-targets in the +1st diffraction order images and -1st diffraction order images; and

separating the individual regions of the first biased sub-targets and the second biased sub-targets to obtain the +1st diffraction order images and -1st diffraction order images of the first biased sub-targets or the second biased sub-targets.

14. A method of selecting a pattern recognition technique for use in determining a measurement region comprising:

obtaining a plurality of variation maps using a plurality of pattern recognition techniques, respectively;

determining a variation of data points of each of the plurality of variation maps so as to obtain a plurality of variations; and

selecting a pattern recognition technique from the plurality of pattern recognition techniques based on the determined plurality of variations.

15. A method as claimed in claim 14, wherein the measurement region is a region of interest, ROI, for parameter of interest inference.

**Fig. 1**

**Fig. 2**

**Fig. 3**

**Fig. 4**

**Fig. 5**

**Fig. 6**

**Fig. 7**

**Fig. 8**

**Fig. 9**

PPB − NPB = A+ (a)

PNB − NNB = A− (b)

AM2_A+    AM3_A+        AM2_A−    AM3_A−

P3_11    P3_1N

P2_11    P2_1N

P1_11    N    P1_1N

M    AM1_A+

Y
X

AM1_A−    (c)

V11    N

M    VM_A+    VM_A−    (d)

VMN

**Fig. 10**

1100

1110

1120

1130

**Fig. 11**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009078708 A1
- WO 2009106279 A1
- US 2011027704 A1
- US 2011043791 A1
- US 20120242970 A1
- US 20100328655 A1
- US 2011102753 A1
- US 20120044470 A1
- US 20110249244 A1
- US 20110026032 A1
- EP 1628164 A2
- US 7791724 B2

- US 7701577 B2
- US 8115926 B2
- US 8553227 B2
- US 8681312 B2
- US 8792096 B2
- US 8823922 B2
- US 8692994 B2
- US 13533110 B
- US 8797554 B2
- WO 2011012624 A1
- US 20160161863 A1
- US 20160370717 A1